Europäisches Patentamt

(19) European Patent Office

Office européen des brevets

(11) **EP 0 398 503 B1**

(12) **EUROPEAN PATENT SPECIFICATION**

(45) Date of publication and mention
of the grant of the patent:
**06.03.1996 Bulletin 1996/10**

(51) Int. Cl.$^6$: **C01G 3/00**, C04B 35/00

(21) Application number: **90304155.6**

(22) Date of filing: **18.04.1990**

(54) **Rare-earth barium copper oxide superconducting materials**

Oxid von seltenen Erden, Barium und Kupfer als supraleitende Materialien

Oxyde de terre rare, baryum et cuivre comme matériaux supraconducteurs

(84) Designated Contracting States:
**CH DE FR GB LI NL SE**

(30) Priority: **19.04.1989 NZ 228820**

(43) Date of publication of application:
**22.11.1990 Bulletin 1990/47**

(73) Proprietor: **HER MAJESTY THE QUEEN IN RIGHT OF NEW ZEALAND**
**Lower Hutt (NZ)**

(72) Inventors:
  • **Tallon, Jeffery Lewis**
    **York Bay, Eastbourne (NZ)**
  • **Pooke, Donald Mark**
    **Lower Hutt (NZ)**
  • **Presland, Murray Robert**
    **Mahina Bay, Eastbourne (NZ)**

(74) Representative: **Perry, Robert Edward et al**
**GILL JENNINGS & EVERY**
**Broadgate House**
**7 Eldon Street**
**London EC2M 7LH (GB)**

(56) References cited:
EP-A- 0 283 620          EP-A- 0 284 438

• **MATERIALS LETTERS, vol. 6, no. 7, April 1988, pages 208-210, Elsevier Science Publishers B.V., NL; M.G. SMITH et al.: "Simple cubic perovskites as components in R1-gammaNagammaBa2Cu3Ox (R=Ce, Pr, Tb)"**
• **PHYSICA C SUPERCONDUCTIVITY, vol. 153-155, part 1, June 1988, pages 898,899, Elsevier Science Publishers B.V., NL; I. Felner et al.: "The effect of substituting potassium for barium on the superconductivity of RBa2Cu307 (R=Y and Eu)"**

**Description**

The present invention comprises novel oxide materials which exhibit bulk superconductivity. Certain of the materials exhibit superconductivity at temperatures exceeding 85K. The invention also relates to processes for their preparation or synthesis.

The oxide compounds $RBa_2Cu_3O_{7-\delta}$ (hereinafter referred to as 1-2-3) and $RBa_2Cu_4O_{8-\delta}$ (hereinafter referred to as 1-2-4) have been shown to be superconductors with superconducting transition temperatures $T_c$, respectively, of 90-93 K (when $\delta<0.15$) and of about 79-81 K. For 1-2-3, $\delta$ may range from 0 to 1.0 while for 1-2-4, $\delta$ lies close to zero. The structure of 1-2-3 is equivalent to a tripled defect perovskite cell with consecutive layers in the unit cell of: R in a B-site with vacant oxygen sites in the layer, a buckled square planar $CuO_2$ layer with Cu in the corner-shared A-sites, a BaO layer with Ba in the B-site, a square-planar $CuO_{1-\delta}$ layer with Cu in the corner-shared A-sites, then the structure repeated in reverse order by a reflection about the $CuO_{1-\delta}$ layer. These materials are typically prepared by solid state reaction of precursor materials, such as $Y_2O_3$, $BaCO_3$ and CuO for 1-2-3, followed by annealing. The $CuO_{1-\delta}$ layer can load or unload oxygen, as described by the value of $\delta$, depending on the temperature of the annealing conditions and the ambient oxygen partial pressure. When fully loaded ($\delta=0$), $T_c$ is a maximum around 92K when R is Y or many of the lanthanide rare-earth elements. In this state the oxygens in the $CuO_{1-\delta}$ layer are ordered onto one set of sublattice sites forming -Cu-O-Cu-O- chains, the otherwise crystallographically equivalent sites being vacant. This ordering renders the material orthorhombic in symmetry. If the anneal temperature is raised above 400°C these oxygens commence to unload from the material ($\delta>0$) and begin to disorder onto the otherwise vacant sites until, at a critical temperature $T_{OT}$, where both sites finally have equal random occupancy, the material undergoes a second-order transition from orthorhombic to tetragonal symmetry.

This transition presents problems in synthesizing and processing the materials for optimum performance. Typically 1-2-3 is oxygen-loaded after synthesis to maximise the superconducting transition temperature by slow cooling or annealing in an oxygen-containing atmosphere to temperatures below 450°C. As the material cools through the transition temperature $T_{OT}$ the thermal expansion becomes large and highly anisotropic resulting in extensive microcracking. This reduces the maximum current-carrying capacity (the so-called critical current) as well as reducing the mechanical strength. The oxygen diffusion coefficient of 1-2-3 is also so low that oxygen loading occurs prohibitively slowly in dense material (<2% porosity).

The structure of 1-2-4 is the same as fully oxygen-loaded 1-2-3 ($\delta=0$) but with the single layer of CuO chains replaced by a double layer of CuO chains displaced 0.5b in the b-direction relative to each other. Because of the stability of the double chain-layer the oxygen stoichiometry remains nearly constant with $\delta$ nearly zero independent of oxygen partial pressure and temperature. This material therefore does not present the same problem of the need to load oxygen in order to prepare superconducting material and its associated problems of a high thermal expansion coefficient and accompanying micro-cracking. However, the transition temperature of 1-2-4 (79 - 81K) is unfortunately too low to be of practical use at the temperature of liquid nitrogen (77 K) due to the deficient electron hole carrier concentration on the $CuO_2$ planes.

Intergrowths of 1-2-3 can occur in 1-2-4 and vice versa. Even in the material 1-2-4 with nominal composition $RBa_2Cu_4O_8$ 1-2-3 intergrowth defects may render the average Cu stoichiometry to be less than 4. Some triple chains may also be possible and in some cases the local Cu stoichiometry may exceed 4. Where 1-2-3 intergrowths occur the single chains may be partially unloaded with oxygen and the oxygen stoichiometry may be less than 8. The chemical formula is thus represented $R_1Ba_2Cu_aO_{8+\delta}$ with $3.9 < a < 4.1$.

R. J. Cava et al, Nature $\underline{338}$:323-330 (1989) disclose $YBa_2Cu_4O_8$, a 1-2-4 compound which has a $T_c$ of 77K, and a method of synthesising that compound.

T. Kogure et al, Physica C, $\underline{156}$:45-56 (1988) disclose compounds having a 2-4-8 structure, $Yb_2Ba_4Cu_8O_x$ and $Y_2Ba_4Cu_8O_x$, and a $T_c$ of around 80K.

According to the present invention, a metal oxide material which exhibits bulk superconductivity has the formula

$$R_{1-x}Ba_{2-y}Ca_{x+y}Cu_4O_{8-\delta}$$

where:

$0 < x < 0.3$ and $0 \leq y < 0.3$ provided that x>y, $-0.25 < \delta < 0.25$

R is Y, La, Nd, Sm, Eu, Gd, Ho, Er, Tm or Yb or any combination thereof,

Ba is Ba or Ba partially substituted by either or both of Sr and La,

Cu is Cu or Cu partially substituted by Ag, Au, Hg, Tl, Bi, Pb, Sb or Ga, or any Periodic Table transition metal element or Group 3A, 4A or 5A metal or any combination thereof, and

O is O or O partially substituted by N, P, S, Se, or F or any combination thereof.

According to the present invention, a process for the preparation of said material comprises reacting precursor materials comprising compounds containing the elements R, Ba, Ca and Cu in an oxygen containing atmosphere, at about atmospheric pressure.

The invention includes a process for preparing the metal oxide materials comprising reacting precursor materials at a temperature T and oxygen partial pressure $Po_2$ satisfying the equation

$$T < 1220 - 180L + 21L^2 \text{ where } L = \log_{10} Po_2.$$

Certain 1-2-4 materials within the scope of the invention have a transition temperature exceeding 85K and certain other desirable properties including reduced or negligible oxygen loading requirements, a reduced thermal expansion coefficient and a reduced tendency to microcrack during synthesis and processing. Certain 1-2-4 materials within the scope of the invention exhibit superconductivity at a temperature up to lOK higher than prior known 1-2-4 materials.

Materials where R is Y are particularly preferred and may be prepared to exhibit superconductivity, having a Tc of 85K or higher.

The materials of the invention will generally be referred to in this specification as substituted 1-2-4.

1-2-4 materials of the invention have Ca substituted on the R and Ba sites in order to increase the carrier concentration and thereby raise $T_C$ from around 79K, to in excess of 85K in certain cases.

In the accompanying drawings that are referred to in the examples:

Fig. 1 shows X-ray diffraction patterns using $CoK\alpha$ radiation for materials of the invention of nominal composition (a) $Y_{0.9}Ca_{0.1}Ba_2Cu_4O_8$ and (b) $Y_{0.8}Ca_{0.2}Ba_2Cu_4O_8$ reacted for a total of 54 hours;

Fig. 2 shows the phase diagram for the Y-Ba-Cu-0 system showing the stability boundary for 1-2-4 as a function of oxygen partial pressure $Po_2$. The dashed line shows the O-T transition in metastable 1-2-3 and the oblique sloping lines show contours of constant composition in metastable 1-2-3 with values of $\delta$ shown;

Fig. 3 shows $CoK\alpha$ XRD patterns for (a) erbium 1-2-4 and (b) erbium 1-2-4 with 10% calcium-substitution. Impurity lines are indicated by dots;

Fig. 4 shows (a) the resistivity, $\rho$ for Ca-substituted erbium 1-2-4 as a function of temperature for various values of x; and (b) the AC susceptibility, $\chi$; and

Fig. 5 shows (a) $T_c$ plotted as a function of x for the erbium 1-2-4 examples 17 to 22. The arrow-bar data, marked R, show the resistive onsets while the data-bar results, marked $\chi$, are the diamagnetic susceptibility onsets; and (b) the c-axis lattice parameters as a function of x.

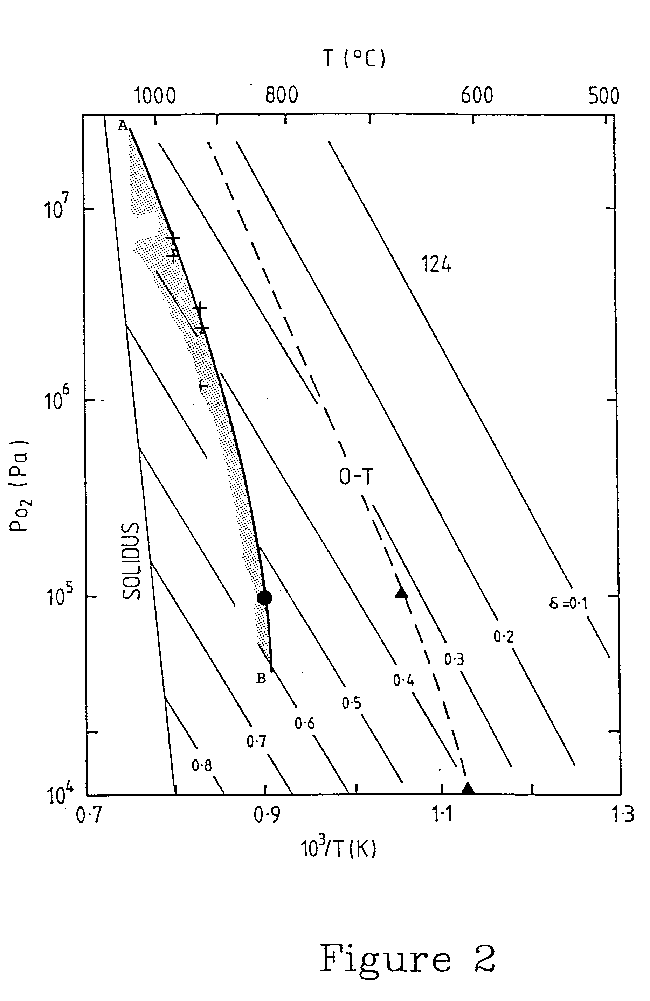

The materials of the invention may be prepared as a thin film using known techniques, or as a bulk material (including thick films). The materials of the invention may be prepared by solid state reaction of the appropriate precursor materials generally by techniques known in the art for preparation of 1-2-3, but with additional reference to the choice of oxygen partial pressures and temperatures lying in the region of 1-2-4 stability shown in Fig. 2. Preparation of 1-2-3 is described in D W Murphy et al, Science 241, 922 (1988) for example.

The material $Y_{1-x}Ba_{1-Y}Ca_{x+y}Cu_4O_8$ may be prepared by solid state reaction of stoichiometric proportions of $Y_2O_2$, $Ba(NO_3)_2$, $Ca(NO_3)_2$ and CuO for example.

Ca may be introduced in the precursor materials in the form of an oxide, chloride, nitrate, hydroxide, or carbonate for example, as may the other precursor elements. The precursors are reacted and sintered at temperatures typically in the range 780°C to 1000°C in an oxygen containing atmosphere at oxygen partial pressures in the range $2 \times 10^4$ Pa to $1 \times 10^7$ Pa, for times in the range 1 to 300 hours. The optimum reaction temperatures and $O_2$ partial pressures will be further described.

Alternatively the precursor materials may be stoichiometrically mixed as nitrates in aqueous or other suitable solution and sprayed as a mist which is passed through an oven, furnace, microwave heating zone or the like for rapid reaction of the discrete droplets. The reacted droplets or particles may then be collected by way of a cyclone, filter, electrostatic precipitator, or the like. The fine reacted particles thus produced may be sintered into a body of arbitrary shape by heating at temperatures and oxygen partial pressures within the 1-2-4 stability region further described below.

The substituted 1-2-4 materials of the invention may be optimally prepared when the reaction and sintering are carried out at a temperature T and oxygen partial pressure $Po_2$ which satisfy the equation

$$T < 1220 - 180L + 21L^2 \text{ where } L = \log_{10} Po_2.$$

Referring to Fig. 2, this formula defines the region marked '124' to the right of the curve A-B which defines the 1-2-4 stability boundary.

As is known in solid state reaction techniques, at intermediate steps the material should preferably be cooled, ground and milled to increase the homogeneity before subjection to further reaction and sintering.

Most preferably reaction and sintering is carried out at a temperature and oxygen partial pressure as close to line A-B, of Fig. 2, as possible. It will be apparent that the substituted 1-2-4 materials of the invention may be prepared at ambient atmospheric pressures or near thereto. For example, $Y_{0.9}Ca_{0.1}Ba_2Cu_4O_8$ may be prepared in $10^5$Pa of flowing oxygen below a temperature of 845°C though, in general, the exact location of this boundary will depend upon the composition and degree of elemental substitution. Because the reaction kinetics are slower in the lower temperature 1-2-4 region, reaction and sintering are preferably performed as close as is practical to the 124 stability boundary (i.e. line A-B in Fig. 2). For example, materials with composition $(Y/Ca)(Ba/Ca)_2Cu_4O_2$ and $(Er/Ca)(Ba/Ca)_2Cu_4O_8$ may be prepared in 1 bar of flowing oxygen at 838°C with and without $Na_2O$ or $K_2O$ as catalysts (as referred to below).

Material prepared at the lower temperature/lower pressure end of the 1-2-4 stability region will be porous and not ideally sintered, but, it may be densified by raising the temperature such that T is greater than that defined by the formula $T = 1220 - 180L + 21L^2$ where $L = \log_{10}Po_2$ (i.e. outside the 1-2-4 stability region) for short duration. The initial sintering rate is faster than the decomposition rate and densification occurs. The material should typically, for example, be further annealed within the 1-2-4 stability region subsequent to densification, and several densification cycles could, for example, be employed. For advanced densification either the temperature or duration of sinter will need to be so large that 1-2-4 will begin to decompose to 1-2-3, or other phases, together with excess copper oxide but on further extended annealing within the stability band 1-2-4 will regrow especially if the precipitates of copper oxides, resulting from the decomposition, are controlled to be finely dispersed. The oxygen partial pressure may be controlled by gas pressure or, alternatively, by use of electrochemical means to control the oxygen activity in the substituted 1-2-4, across the entire stability region shown in Fig. 2, by placing an oxygen-ion electrolyte conductor such as Y-stabilised $ZrO_2$ in contact with the material and maintaining an appropriate voltage across the cell thus formed according to the known methods of solid-state electrolyte cells, for example.

The reaction rate may be enhanced by the use of certain alkali metal fluxes, catalysts, or reaction rate enhancers which may operate by providing a molten or vapour flux or by temporary or permanent substitution into the lattice of the reactants or the final product. Such fluxes, catalysts or reaction rate enhancers for the preparation of substituted 1-2-4 materials comprise: the oxides, nitrates, carbonates, halides and hydroxides of the alkali metals. For example, in the preparation of Ca-substituted 1-2-4 the Ca is introduced in the precursor materials and an alkali metal catalyst such as the oxides of Na and K, which are preferred, may also be introduced in the precursor materials as $NaNO_3$ or $KNO_3$ which will decompose to their respective oxides. The attractive feature of these catalysts is that they are volatile and will, with time, evaporate off leaving phase-pure Ca-substituted 1-2-4. Further catalyst may be added as required at intermediate grinding and milling steps. The alkali metal may also be introduced, where the end material is to be Na or K substituted 1-2-4 for example, and the reaction carried out at reduced temperatures in a sealed reaction vessel to minimise volatilization of the alkali. It is preferable to employ small amounts only of alkali catalyst, preferably the oxides of Na or K in the preparation of Ca substituted 1-2-4, which are present during synthesis and which evaporate away during synthesis leaving sintered ceramic product. The mole fraction of introduced flux, catalyst or reaction rate enhancers may be less than 1.0 and is preferably in the range 0.1 to 0.2. This enables the synthesis of ceramic product, as opposed to powder.

Ca substituted 1-2-4 materials prepared with or without alkali metal catalyst as described may alternatively be defined by the formula

$$R_{1-\alpha x}Ba_{2-(1-\alpha)x}Ca_xCu_4O_{8-\delta}$$

where x lies in the range of $0<x<0.3$ and is the mole fraction of substituted Ca, preferred materials include those where x = 0.025, 0.05, 0.075, 0.1, 0.125, 0.15, 0.2 or 0.3; and the fraction $\alpha$ is in the range $0.5 < \alpha < 1$ and is the proportion of Ca which substitutes on the rare earth or Y-site, the remaining fraction $(1-\alpha)$ substitutes on the Ba-site. When prepared using an alkali metal catalyst some alkali metal may also be present on either or both of those sites.

A preferred example of a substituted 1-2-4 oxide material is:

$R_{1-x}Ba_{2-y}Ca_{x+y}Cu_4O_{8-\delta}$, with $0<x+y<0.3$ and $-0.25<\delta<0.25$ $R_{1-x}Ca_xBa_{2-y}La_yCu_4O_{8-\delta}$, all with $-0.25<\delta<0.25$ and $O<x,y<1$

The materials of the invention and their preparation are further illustrated by the following examples.

Example 1

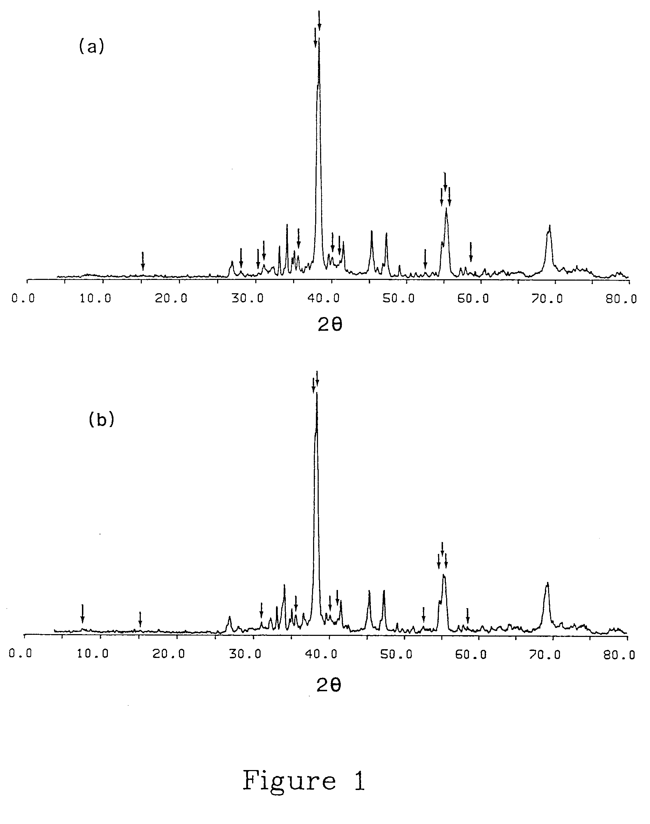

Samples of nominal composition $Y_{0.9}Ca_{0.1}Ba_2Cu_4O_8$ and $Y_{0.8}Ca_{0.2}Ba_2Cu_4O_8$ were prepared by reacting stoichiometric proportions of $Y_2O_3$, $Ca(NO_3)$, $Ba(NO_3)_2$ and submicron sized powders of CuO. The mixtures were first decomposed for 1 hour at 700°C, the ground, milled and pelletised. The pellets were reacted at 800°C in flowing oxygen for a total of 54 hours with four or five intermediate grindings each involving milling and die-pressing as pellets. Fig. 1 shows X-ray diffraction patterns from these reacted materials and reflections corresponding to the desired substituted 1-2-4 phase are marked with arrows. The yield is estimated to be 15 to 20%. The following examples show that the inclusion of alkali fluxes allows accelerated reaction through to 100% 1-2-4 phase.

4

Examples 2 - 12

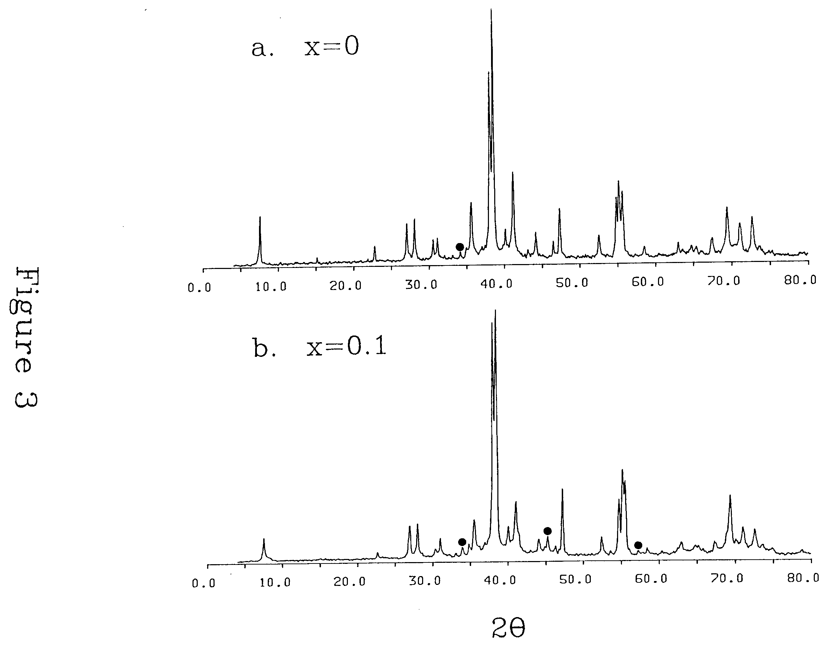

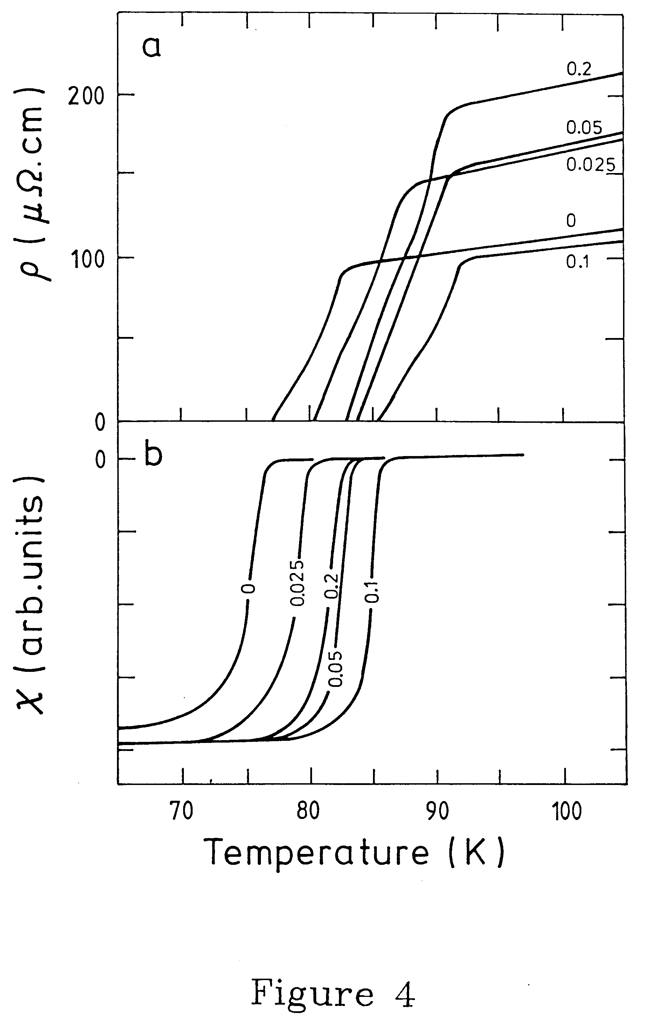

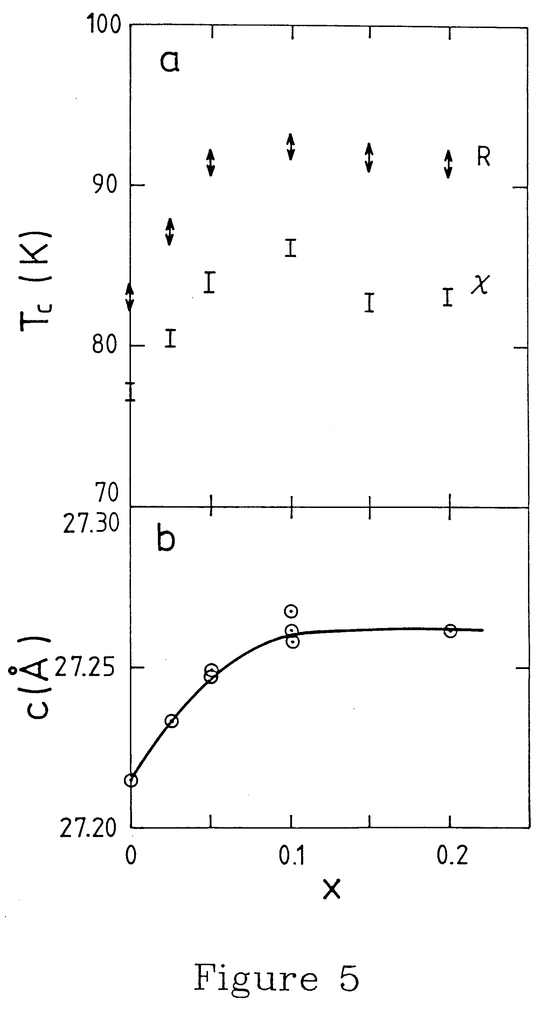

Samples of calcium substituted $YBa_2Cu_4O_8$ and $ErBa_2Cu_4O_8$ were prepared by reaction with 0.2 mole fraction of $NaNO_3$ catalyst and from stoichiometric quantities of $Y_2O_3$ or $Er_2O_3$ as appropriate, $Ba(NO_3)_2$, $Ca(NO_3)_2$ and sub-micron sized CuO in flowing oxygen at 1 bar. The reaction temperatures were between 805 and 815°C for the Er materials and 815 and 830°C for the Y materials. The compositions investigated assume that 75% of the Ca substitutes on the R-site and 25% substitutes on the Ba-site. These are the ratios we have found for Ca-substitution in 1-2-3 by X-ray diffraction (of compounds with a range of nominal ratios) and confirmed by neutron diffraction. Nominally unsubstituted 1-2-4 was reacted with $NaNO_3$ catalyst at higher temperatures in order to find the stability limit for 1-2-4 in oxygen at 1 bar. (The nominally unsubstituted 1-2-4 samples will inevitably contain some substituted alkali originating from the alkali catalyst). The stability limit was found to be 840°C and this point is the filled circular data point shown in Fig. 2. This, together with data reported at high pressures between 20 and 100 bar (Physica C $\underline{159}$ (1989) 287) allows the construction of the boundary line A-B shown in Fig. 2. 1-2-4 samples prepared at temperatures below this boundary will progress to the required single-phase products given sufficient reaction time. The precursor materials for the substituted 1-2-4 together with catalyst were mixed and decomposed at 750°C in air for 1 hour. The residue was pressed into pellets and reacted in flowing oxygen as above. At 12, 24 and 36 hours the pellets were rapidly withdrawn from the furnace, ground and milled and re-pressed into pellets for further reaction, then left for a further 3 to 5 days sintering under the same reaction conditions. The result was nearly single-phase material as indicated by the X-ray diffraction patterns for Examples 2 and 5. Fig.3 shows the X-ray ($CoK\alpha$) diffraction patterns for examples 2 and 5. The pattern shows nearly single-phase material. Impurity reflections are marked by dots. Fig. 4 shows AC susceptibility, $\chi$ and resistivity, $\rho$ for examples 2 to 5 and 7 covering a range of calcium substitution levels, x. Fig. 5 shows the c-axis lattice parameter as a function of x, confirming that Ca is substituting in the 1-2-4 compound, though the solubility limit appears to be x=0.1. The resistive onset (R) temperature is plotted as well as the susceptibility onset ($\chi$) temperature. The resistive onset rises to a maximum of 93K for x=0.1 and the susceptibility onset rises to a maximum of 86K for x=0.1. $T_c$ values were observed to be approximately 1K higher for the Y-samples. The same result could be obtained without the alkali catalyst but the reaction period had to be much longer and magnetic measurements displayed multiple transitions indicating that residual defect

EP 0 398 503 B1

intergrowths persist in these materials prepared without catalyst.

| Example | Composition (atomic ratio) | | | | | $T_c$(K) | c(Å) |
|---|---|---|---|---|---|---|---|
| | | | | | | R=O | |
| | Y | Er | Ca | Ba | Cu | | |
| 2 | | 1 | 0 | 2 | 4 | 77 | 27.215 |
| 3 | | 0.981 | .025 | 1.994 | 4 | 81 | 27.235 |
| 4 | | 0.962 | .05 | 1.988 | 4 | 84 | 27.250 |
| 5 | | 0.925 | .1 | 1.975 | 4 | 86 | 27.260 |
| 6 | | 0.888 | .15 | 1.962 | 4 | 82 | |
| 7 | | 0.85 | .2 | 1.95 | 4 | 83 | 27.260 |
| 8 | 1 | | 0 | 2 | 4 | 78 | 27.244 |
| 9 | .962 | | .05 | 1.988 | 4 | | 27.275 |
| 10 | .944 | | .075 | 1.981 | 4 | 87 | 27.259 |
| 11 | .925 | | .1 | 1.975 | 4 | 86 | 27.259 |
| 12 | .906 | | .125 | 1.969 | 4 | 86 | 27.253 |

*Examples 2 and 8 are comparative examples.*

The foregoing describes the invention including preferred forms and examples thereof. The preparation of derivative materials and forms other than sintered ceramic form, i.e. thin films, thick films, single crystals, filiaments and powders other than those specifically examplified will be within the scope of those skilled in the art in view of the foregoing. The scope of the invention is defined in the following claims.

## Claims

1. A metal oxide material which exhibits bulk superconductivity with the formula

$$R_{1-x}Ba_{2-y}Ca_{x+y}Cu_4O_{8-\delta}$$

where:
$0 < x < 0.3$, $0 \leq y < 0.3$, and $x>y$, $-0.25 < \delta < 0.25$, and
R is Y, La, Nd, Sm, Eu, Gd, Ho, Er, Tm or Yb or any combination thereof.

6

2. The material of claim 1, wherein the ratio of x:y is about 75:25.

3. The material of claim 1 or claim 2, wherein x + y is in the range of 0.075 to 0.125.

4. The material of claim 3, wherein x+y equals about 0.1.

5. The material of any of the preceding claims, wherein R is Y or Er.

6. A process for forming a material of any of the preceding claims, the process comprising reacting precursor materials comprising compounds containing the elements R, Ba, Ca and Cu in an oxygen containing atmosphere, at about atmospheric pressure.

7. The process of claim 6, wherein said oxygen containing atmosphere is flowing oxygen.

8. A process for forming a material of any of claims 1 to 5, the process comprising reacting precursor materials at an oxygen partial pressure $Po_2$ (in Pa) in the range $10^4$ to $10^7$ Pa and a temperature T (in °C) satisfying the equation

$$T < 1220 - 180L + 21L^2, \text{ where } L = \log_{10} Po_2.$$

9. The process of any of claims 6 to 8, wherein said reaction is carried out in the presence of a flux, catalyst or reaction rate enhancer comprising a compound of an alkali metal.

10. The process of any one of claims 6 to 9, wherein the precursor materials are selected from nitrates, hydroxides, oxides, chlorides and carbonates.

**Patentansprüche**

1. Ein Metalloxidmaterial, das eine Hochleistungs-Supraleitfähigkeit aufweist, mit der Formel

$$R_{1-x}Ba_{2-y}Ca_{x+y}Cu_4O_{8-\delta}$$

wobei:
$0 < x < 0{,}3$, $0 \leq y < 0{,}3$, und $x>y$, $-0{,}25 < \delta < 0{,}25$, und
R gleich Y, La, Nd, Sm, Eu, Gd, Ho, Er, Tm oder Yb oder jede beliebige Kombination daraus ist.

2. Das Material gemäß Anspruch 1, in dem das Verhältnis x:y etwa 75:25 beträgt.

3. Das Material gemäß Anspruch 1 oder Anspruch 2, in dem x - y im Bereich 0,075 bis 0,125 liegt.

4. Das Material gemäß Anspruch 3, in dem x+y etwa 0,1 beträgt.

5. Das Material gemäß einem beliebigen der vorstehenden Ansprüche, in dem R gleich Y oder Er ist.

6. Ein Verfahren zum Bilden von Material eines beliebigen der vorstehenden Ansprüche, wobei der Prozeß Vorläuferreagenzien einschließlich Verbindungen, die die Elemente R, Ba, Ca und Cu enthalten, umfaßt, in einer sauerstoffhaltigen Atmosphäre unter etwa atmosphärischem Druck.

7. Das Verfahren gemäß Anspruch 6, in dem die sauerstoffhaltige Atmosphäre strömender Sauerstoff ist.

8. Ein Verfahren zum Bilden von Material gemäß einem beliebigen der Ansprüche 1 bis 5, wobei das Verfahren Vorgängerreagenzien umfaßt, unter einem Sauerstoffpartialdruck $Po_2$ (in Pa) im Bereich $10^4$ bis $10^7$ Pa und bei einer Temperatur T (in °C), die der folgenden Gleichung genügt

$$T < 1220 - 180L + 21L^2, \text{ wobei } L = \log_{10} Po_2.$$

9. Das Verfahren gemäß einem der Ansprüche 6 bis 8, in dem die Reaktion ausgeführt wird in Anwesenheit eines Flußmittels, eines Katalysators oder eines Reaktionsratenverstärkers, der eine Verbindung eines Alkalimetalls enthält.

**10.** Das Verfahren gemäß einem beliebigen der Ansprüche 6 bis 9, in dem die Vorläufermaterialien aus Nitraten, Hydroxiden, Oxiden, Chloriden und Carbonaten ausgewählt werden.

**Revendications**

**1.** Matériau d'oxyde métallique qui présente une supraconductivité dans la masse de formule :

$$R_{1-x}Ba_{2-y}Ca_{x+y}Cu_4O_{8-\delta}$$

dans laquelle :

$0 < x < 0,3$, $0 \leq y < 0,3$, et $x > y$, $- 0,25 < \delta < 0,25$, et

R est Y, La, Nd, Sm, Eu, Gd, Ho, Er, Tm ou Yb ou une combinaison quelconque de ceux-ci.

**2.** Matériau selon la revendication 1, dans lequel le rapport de $x : y$ se trouve d'environ 75:25.

**3.** Matériau selon la revendication 1 ou la revendication 2, dans lequel $x + y$ se trouve dans l'intervalle de 0,075 à 0,125.

**4.** Matériau selon la revendication 3, dans lequel $x+y$ est égal à environ 0,1.

**5.** Matériau selon l'une quelconque des revendications précédentes, dans lequel R est Y ou Er.

**6.** Procédé de formation d'un matériau selon l'une quelconque des revendications précédentes, le procédé consistant à faire réagir des matériaux de précurseurs comprenant des composés contenant les éléments R, Ba, Ca et Cu dans une atmosphère contenant de l'oxygène à environ la pression atmosphérique.

**7.** Procédé selon la revendication 6, dans lequel ladite atmosphère contenant de l'oxygène est de l'oxygène en écoulement.

**8.** Procédé de formation d'un matériau selon l'une quelconque des revendications 1 à 5, le procédé consistant à faire réagir des matériaux de précurseurs à une pression partielle d'oxygène $PO_2$ (en Pa) dans l'intervalle de $10^4$ à $10^7$ Pa et à une température T (en °C) satisfaisant l'équation :

$$T < 1220 - 180L + 21L^2, \text{ dans laquelle } L = \log_{10}PO_2.$$

**9.** Procédé selon l'une quelconque des revendications 6 à 8, dans lequel on réalise ladite réaction en présence d'un fondant, d'un catalyseur ou d'un activeur de vitesse de réaction comprenant un composé d'un métal alcalin.

**10.** Procédé selon l'une quelconque des revendications 6 à 9, dans lequel les matériaux de précurseurs sont choisis parmi des nitrates, des hydroxydes, des oxydes, des chlorures et des carbonates.

(a)

$2\theta$

(b)

$2\theta$

Figure 1

Figure 2

Figure 3

a.  x=0

b.  x=0.1

2θ

Figure 4

Figure 5